# EUROPEAN PATENT SPECIFICATION

(11) **EP 0 593 247 B1**
(45) Date of publication and mention of the grant of the patent: **13.03.2002**
(21) Application number: 93308097.0
(22) Date of filing: 12.10.1993
(51) Int. Cl.: H01L 27/11, H01L 21/82

(54) **Semiconductor memory device and manufacturing method therefor**
Halbleiter-Speicherbauteil und Verfahren zu seiner Herstellung
Dispositif à mémoire semi-conducteur et procédé de fabrication associé

(30) Priority: 12.10.1992 KR 9218694
(43) Date of publication of application: 20.04.1994
(73) Proprietor: SAMSUNG ELECTRONICS CO. LTD., Suwon, Kyungki-do (KR)
(72) Inventor: Kim, Han-Soo, Kwonsun-gu, Suwon-city, Kyungki-do (KR); Kim, Kyung-tae, Songpa-gu, Seoul (KR)
(74) Representative: Ertl, Nicholas Justin

(56) References cited:
- US-A- 4 125 854
- US-A- 4 725 875
- INTERNATIONAL ELECTRON DEVICES MEETING, December 1990, SAN FRANCISCO, CA, USA pages 477 - 480, XP279593 T. YAMANAKA ET AL. 'A 5.9um2 SUPER LOW POWER SRAM CELL USING A NEW PHASE-SHIFT LITHOGRAPHY'
- PATENT ABSTRACTS OF JAPAN vol. 7, no. 288 (E-218) 22 December 1983 & JP-A-58 165 375 (FUJITSU) 30 September 1983
- PATENT ABSTRACTS OF JAPAN vol. 16, no. 263 (E-1216) 15 June 1992 & JP-A-04 061 160 (TOSHIBA) 27 February 1992
- INTERNATIONAL ELECTRON DEVICES MEETING, December 1991, WASHINGTON, DC, USA pages 481 - 484 H. OHKUBO ET AL. '16 Mbit SRAM CELL TECHNOLOGIES FOR 2.0 V OPERATION'
- INTERNATIONAL ELECTRON DEVICES MEETING, December 1991, WASHINGTON, DC, USA pages 477 - 480, XP342182 K. ITABASHI ET AL. 'A SPLIT WORDLINE CELL FOR 16 Mb SRAM USING POLYSILICON SIDEWALL CONTACTS'
- SYMPOSIUM ON VLSI TECHNOLOGY, June 1990, HONOLULU pages 19 - 20, XP164398 A. O. ADAN ET AL. 'A HALF-MICRON SRAM CELL USING A DOUBLE-GATED SELF-ALIGNED POLYSILICON PMOS THIN FILM TRANSISTOR (TFT) LOAD'
- IEEE SC-21,no.5,Oct.86,pgs.704-712
- IEDM Dec.91,pgs.481-484
- IEDM Dec.91,pgs.477-480

## Description

The present invention relates to a semiconductor memory device and a manufacturing method thereof, and more particularly, to a semiconductor memory device for the high packing density and a method for manufacturing the memory device.

A static random access memory (SRAM) cell formed of two access transistors, two driver transistors, and two load elements is under research in many aspects.

Though the memory capacity of an SRAM is less than that of a dynamic random access memory (DRAM), SRAM application is simple and its operation is fast. Accordingly, SRAMs have been widely adopted as the memory for small to medium-sized systems, e.g., a microcomputer system or computer terminal apparatus.

SRAM cells are classified into three types depending on the particular load element employed in the flip-flop. These are: a depletion load type using a depletion-type NMOS transistor as the load element, a high-resistance polysilicon load type using a high-resistance polysilicon as the load element, and a CMOS type using a PMOS transistor as the load element.

Among these, in the SRAM memory cell of the CMOS type, the standby current is less than that of the other types, such that the power consumption power is reduced remarkably, which solves the power consumption problem of the high-resistance polysilicon load type memory cell. Further benefits concerning soft-error immunity and cell stability have resulted in the introduction of the CMOS-type cell as the SRAM cell of the next generation.

However, when manufacturing a CMOS-type memory cell, the two-dimensional space (area) occupied by one memory cell, which is the main factor in determining integration, is significantly enlarged. This is due to the fact that while six transistors (two NMOS access transistors, two NMOS driver transistors, and two PMOS transistors) are formed together on the semiconductor substrate in the case of a CMOS-type memory cell, the high-resistance polysilicon load type cell has only four transistors (two NMOS access transistors and two NMOS driver transistors) formed on the semiconductor substrate, with the high-resistance polysilicon load element being formed above the transistors.

On the other hand, a new method has been introduced for the CMOS-type memory cell. Conventionally, wells of both types (N-type and P-type) had been formed in one semiconductor substrate, having four NMOS transistors and two PMOS transistors located thereon, but in the new method, only two NMOS access transistors and two NMOS driver transistors are formed on the substrate and then a PMOS thin film transistor (TFT) is laid over the transistors. In doing so, a CMOS-type memory cell is obtained in which a unit cell thereof occupies as much area as in the case of an SRAM device using high-resistance polysilicon as the load element.

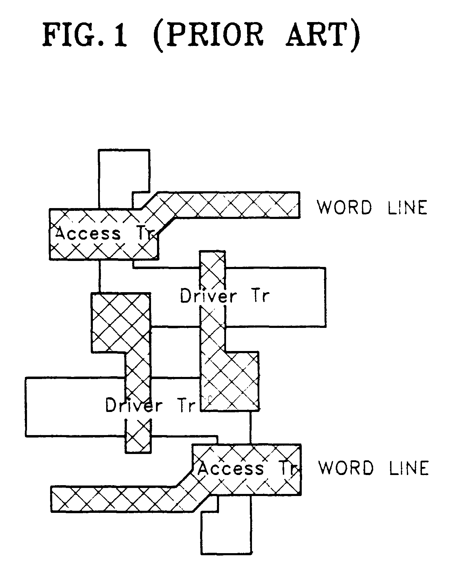

In addition, the layout of a CMOS memory cell having access transistors and driver transistors on a semiconductor substrate is illustrated in a disclosure entitled "16Mbit SRAM Cell Technologies for 2.0V Operation" (an NEC paper by H. Ohkubo et al., IEDM '91). Here, an insulating film is deposited on the transistors, to form a PMOS TFT. As shown in figure 1 of the above paper, a PMOS TFT can be located within the area occupied by the access transistor and driver transistor. Accordingly, integration is not lowered when manufacturing using PMOS TFTs.

FIG.1 of the accompanying drawings illustrates the layout of the SRAM cell which is carried in the above paper by NEC Corporation and a disclosure entitled "A Split Wordline Cell for 16Mb SRAM Using Polysilicon Sidewall Contacts" (a Fujitsu paper by Kazuo Itabashi et al., IEDM '91)

As shown in FIG.1, each word line, being respectively located in the upper and lower portions of one memory cell, acts as the gate of an access transistor. Here, by contrast with a paper entitled "A Half-micron SRAM Cell Using a Double-gated Self-aligned Polysilicon PMOS Thin Film Transistor (TFT) Load" by A.O. Adan et al., 1990 Symposium on VLSI Technology) in which one word line performs the joint function of the gates of two transistors and thereby complicates the structure of the active region, FIG. 1 shows a simplified structure whereby a rectangular active region results when manufacturing the SRAM cell. Accordingly, the occupied area of the unit cell is greatly decreased so that high integration is accomplished. Also, the encroachment of the bird's beak into the active region, which is inevitable with the above complicated structure, is decreased. Thus, the reliability of the memory cell is enhanced and the process margin is increased.

However, as presented by the above papers, the memory cell includes a word line which is formed together with the gate of a driver transistor from the same layer while serving as the gate of an access transistor and being serially connected to the adjacent memory cell. In such a memory cell, the gate of the driver transistor, the gate of the access transistor and the word line are all formed together by patterning the same conductive layer. Accordingly, if the gates of the driver transistors are located between each wordline disposed respectively on the upper and lower portion of one memory cell, the area occupied by the memory cell is determined by the pitch between the above word lines and the driver transistor gates.

As described above, when the word line is formed from the same layer with the driver transistor so as to be serially connected to the adjacent memory cell, it is difficult to reduce the cell area. Cell area reduction is considered a must for the manufacture of highly integrated SRAM devices.

Accordingly, one object of the present invention is to provide a semiconductor memory device wherein the gates of the access transistors are formed from a different conductive layer than that for the word lines.

Another object of the present invention is to provide a semiconductor memory device in which the area occupied by a unit cell is minimized while maintaining the conventional design rule.

JP 58165375 discloses a method for improving the operating speed of a semiconductor memory device by forming word lines and power source lines of a good conductive material, different from that use for a wiring layer for a gate electrode.

USP 4,125,854 discloses a symmetrical structural layout for the principal components of each of four cells in a group of four mutually contiguous cells of an array of memory cells.

JP 4061160 discloses a method to remove a parasitic TFT operation by forming a first thin-film constituting a first gate electrode, and a third thin-film creating a second gate electrode on respective sides of a second thin film which includes a channel region.

According to the present invention, a semiconductor memory device including a first memory cell composed of cross-connected flip flops in which a first inverter having a first access transistor and first driver transistor and a second inverter having a second access transistor and second driver transistor form one flip-flop and a third inverter having a first load element and the first driver transistor and a fourth inverter having a second load element and the second driver transistor form the other flip-flop said device comprises:
a semiconductor substrate;
a first conductive layer formed on said substrate wherein said first and second access transistors each have a gate formed from said first conductive layer;
an insulating layer formed on said first and second access transistor gates, said insulating layer having a first and second contact hole therein to expose said first and second access transistor gates, respectively;
a second conductive layer formed on said insulating layer;
a first and second word line formed from said second conductive layer, said first word line being connected to said first access transistor gate through said first contact hole, and said second word line being connected to said second access transistor gate through said second contact hole, wherein said first and second access transistor gates (14) are disposed parallel to said first and second word lines (30,34) respectively said first and second driver transistor gates (16,18) are formed perpendicular to said first and second access transistors gates (14) respectively and wherein said first access transistor gate (14) of said first memory cell is connected to a first access transistor gate of an adjacent second memory cell in which,
said first access transistor gate (14) of said first memory cell is connected to a first access transistor gate of an adjacent second memory cell; and,
said second access transistor gate of said first memory cell is connected to a second access transistor gate of an oppositely adjacent third memory cell;
said first access transistor gate (14) of said first memory cell does not directly contact a first access transistor gate of said third memory cell; and,
said second access transistor gate of said first memory cell does not directly contact a second access transistor gate of said second memory cell.

Embodiments of the present invention will now be described, by way of example, with reference to the accompanying drawings, in which:
FIG.1 is a diagram of the layout of the conventional semiconductor memory device wherein the gate of an access transistor and a word line are formed from the same layer;
FIGs.2 to 11 are diagrams pertaining to the layout of a semiconductor memory device according to an embodiment of the present invention, wherein the gate of an access transistor and a word line are formed from the different layers;
FIGs.12 to 21 are cross-sectional views taken along line AA' of each diagram of the layout as illustrated in FIGs.2 to 11, for illustrating the method for manufacturing the semiconductor memory device according to the present invention; and
FIGs.22 to 31 are cross-sectional views taken along line BB' of each diagram of the layout as illustrated in FIGs.2 to 11, for illustrating the method for manufacturing the semiconductor memory device according to an embodiment of the present invention.

Hereinbelow, the preferred embodiments of the present invention are described in more detail, referring to the attached drawings.

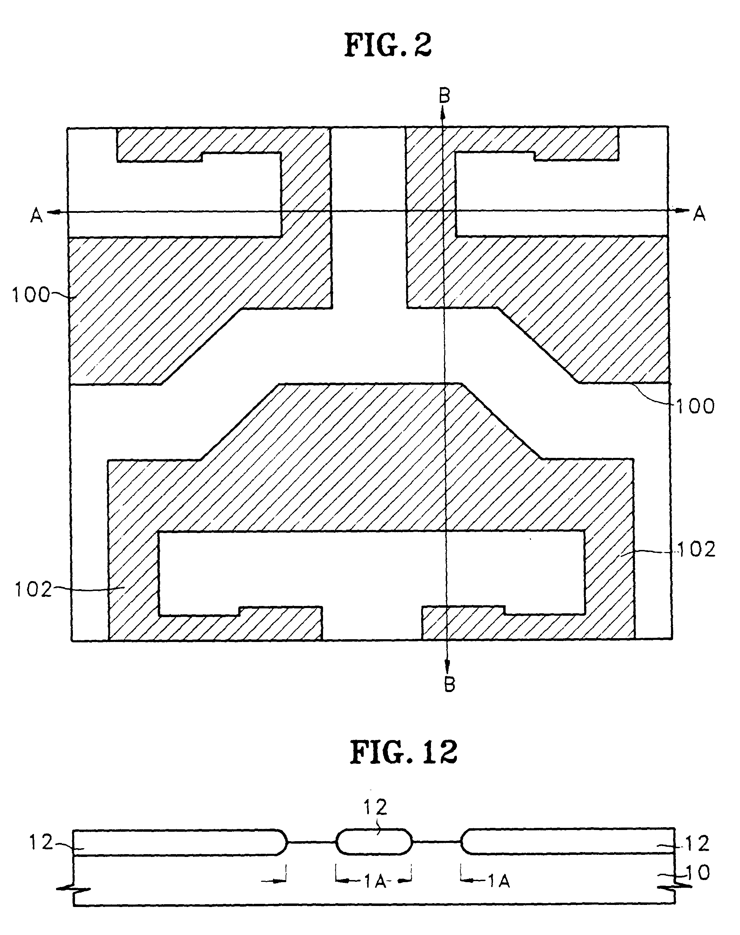

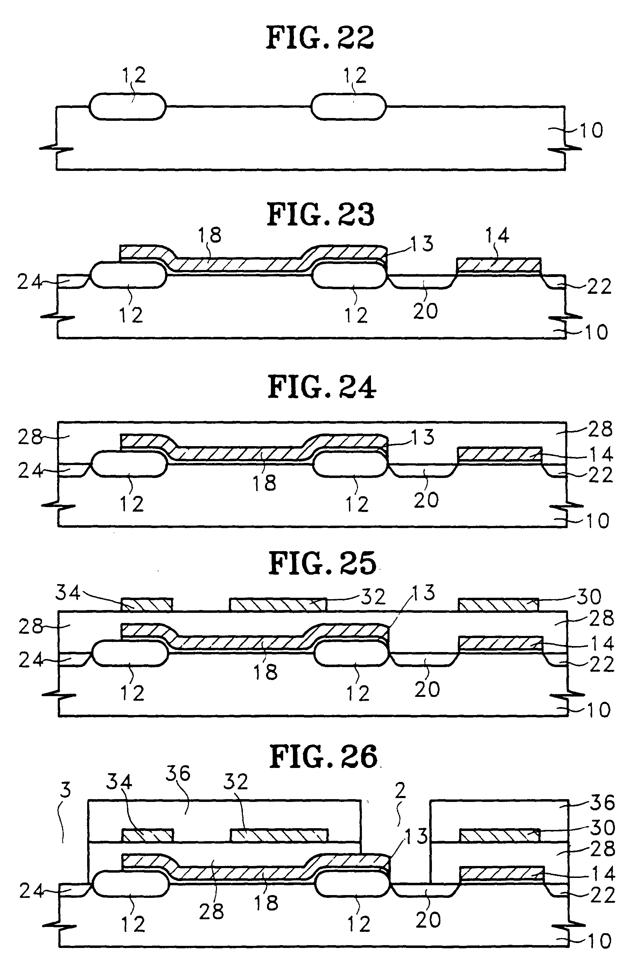

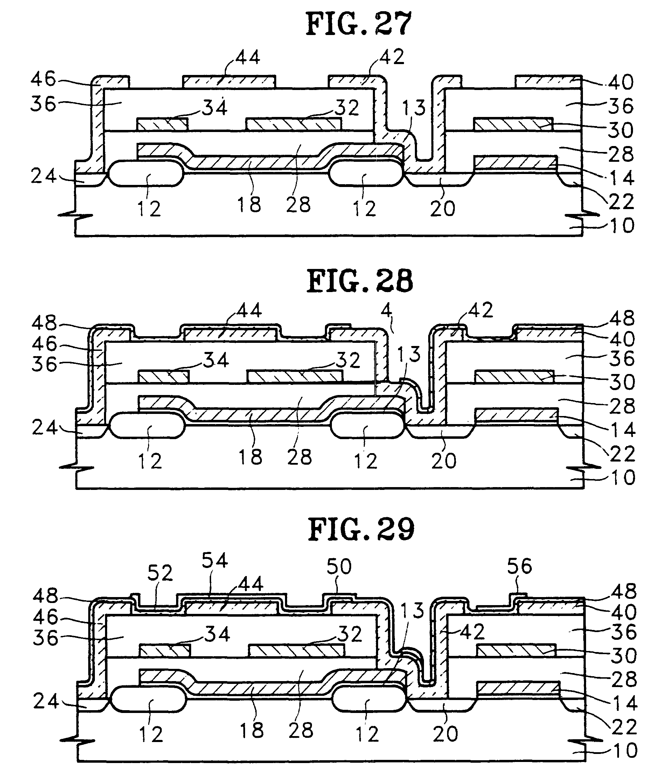

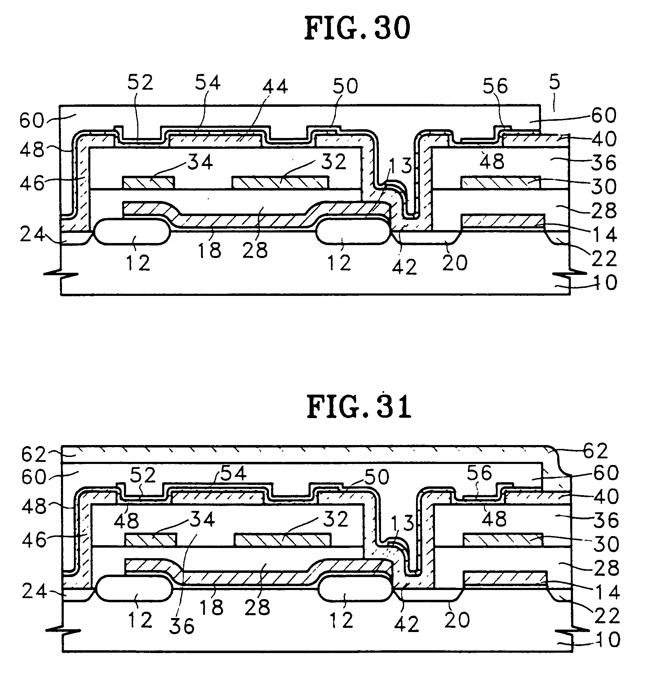

FIGs.2 to 11 are layout diagrams of the SRAM cell according to an embodiment of the present invention. Here, the shaded portions in each diagram represent the mask patterns included in one masked area. Also, the cross-sectional views of lines AA' and BB' of FIGs. 2 to 11 are shown in FIGs.12 to 21 and FIGs.22 to 31, respectively, and further illustrate the processes for manufacturing the SRAM cell.

FIGs.2, 12 and 22 illustrate the step for forming a field oxide film 12, using mask patterns 100 and 102 to form a first active region 1A and a second active region 1B.

Sequentially, a pad oxide film (not shown) and a nitride film pattern (not shown) are formed on a semiconductor substrate 10, and then the exposed substrate is oxidized by the nitride film pattern according to conventional selective oxidation processes, so as to form a field oxide film 12 defining first active region 1A and second active region 1B. Thereafter, the nitride film pattern and the pad oxide film are removed.

Here, the first and second active regions are arranged symmetrically with respect to each other as well as the active regions of adjacent memory cells. Also, the memory cell components are arranged symmetrically with respect to one another.

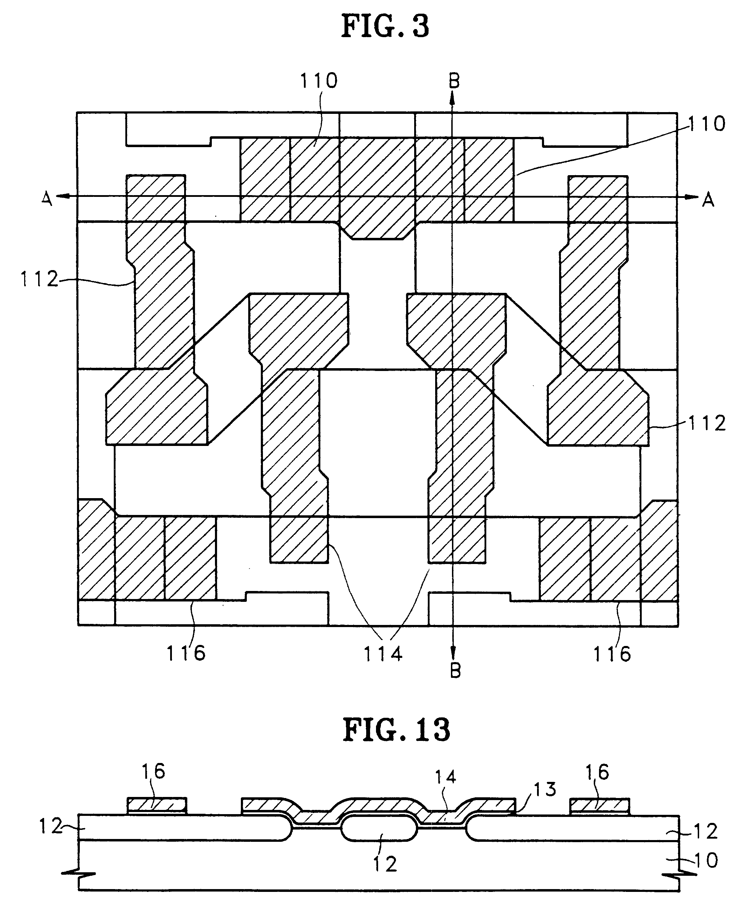

FIGs.3, 13, and 23 illustrate the step for forming the first access transistor, the first driver transistor, the second access transistor, and the second driver transistor, using mask patterns 110, 112, 114 and 116, in order to form a gate 14 of the first access transistor, a gate 16 of the first driver transistor, a gate 18 of the second driver transistor and the gate (not shown) of the second access transistor.

After a gate insulating film 13 of the first and second access transistors and that of the first and second driver transistors are formed over the entire surface of semiconductor substrate 10 where field oxide film 12 is formed, a conductive material, e.g., polysilicon or a lamination of polysilicon and silicide, is deposited over the above gate insulating film 13 to form the first conductive layer (not shown). Then, the first conductive layer is patterned by a photo-etching process using mask patterns 110, 112, 114 and 116, so that gate 14 of the first access transistor, gate 16 of the first driver transistor, gate 18 of the second driver transistor and the gate of the second access transistor are respectively formed. Gate 14 of the first access transistor is disposed near the edge of each memory cell, extending across the first active region (reference numeral 1A in FIG.12.) and connecting to the gate of the first access transistor of an adjacent memory cell. Each connected gate is arranged such that it is separated from the gates of adjacent memory cells. Gate 16 of the first driver transistor is disposed in the center portion of each memory cell, extending across the first active region and perpendicularly to gate 14 of the first access transistor. Also, gate 18 of the second driver transistor is disposed in the center portion of each memory cell, extending across the second active region (reference numeral 1B in FIG.12.) and parallel to gate 16 of the first driver transistor, and the gate of the second access transistor is disposed near the edge of each memory cell, extending across the second active region and connecting to the gate of the second access transistor of the oppositely adjacent memory cell. Here, too, each connected gate is arranged such that it is separated from the gates of adjacent memory cells.

Then, an impurity, e.g., phosphorus or arsenic, is ion-implanted on the entire surface of the resultant substrate where the gates of the above transistors are disposed, so as to form source region 20 (or drain region) and drain region 22 (or source region) of the first access transistor, form the source region (not shown) and drain region 20 of the first driver transistor, form the source and drain regions (not shown) of the second driver transistor, and form the source region (or the unshown drain region) and drain region 24 (or source region) of the second access transistor. Thus, the respective transistors are completed.

Here, source region 20 and drain region 22 of the first access transistor, and the source region and drain region 20 of the first driver transistor are arranged in the first active region, while the source region of the first access transistor and the drain region of the first driver transistor are commonly occupied. Also, the source and drain regions of the second driver transistor, and the source region and drain region 24 of the second access transistor are arranged in the second active region, while the drain region of the second driver transistor and the source region of the second access transistor are commonly occupied.

Here, a comparison is made between the layout of the conventional SRAM cell (as illustrated in FIG.1) and that of the present invention (as illustrated in FIG.3).

The layout of FIG. is formed such that the gates of the access transistors are respectively arranged near the edge of the upper and lower parts of each memory cell, so as to be connected to the adjacent memory cells throughout the memory cell array. On the other hand, the structure of the layout of FIG.3 is one wherein the gate of the access transistor arranged in the upper part of each memory cell is connected to that in the upper part of an adjacent memory cell, while the gate of the access transistor arranged in the lower part of a memory cell is connected to that in the lower part of the oppositely adjacent memory cell, with each connected gate being separated from those of adjacent memory cells.

That is, according to the layout of the present invention, the area occupied by the gates of the access transistors and driver transistors, which indirectly determines the area of a memory cell using the conventional design rule, can be reduced. This in turn reduces the unit cell area and allows for the process margin to be increased.

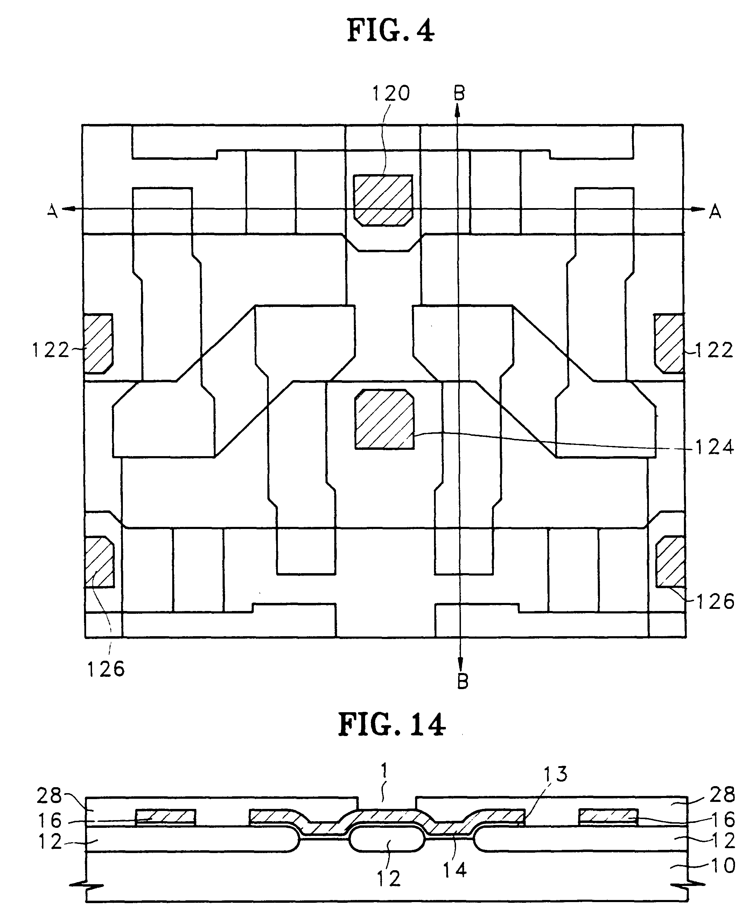

FIGs.4, 14 and 24 illustrate the step for forming first through fourth contact holes using mask patterns 120, 122, 124 and 126, respectively. Here, the first contact hole 1 is for linking a first word line with gate 14 of the first access transistor, the second contact hole (not shown) is for linking a first power supply wiring with the source region of the first driver transistor, the third contact hole (not shown) is for linking the first power supply wiring with the source region of the second driver transistor, and the fourth contact hole (not shown) is for linking a second word line with the gate of the second access transistor.

After a first insulating layer 28 is formed over the entire surface of the resultant substrate where the above transistors are arranged, the first insulating layer is selectively removed by a photo-etching process using mask patterns 120, 122, 124 and 126, so that first contact hole 1 exposes the surface of gate 14 of the first access transistor, the second contact hole exposes the surface of the source region of the first driver transistor, the third contact hole exposes the surface of the source region of the second driver transistor, and the fourth contact hole exposes the surface of the gate of the second access transistor, respectively.

Here, first insulating layer 28 is provided for insulating the gates of the transistors from the word line formed in a subsequent process step, and adopts a monolayer of an oxide film, e.g., a high-temperature oxide (HTO) film. If an insulating material. e.g., boro-phosphor-silicate glass (BPSG), is laid over the HTO film, the surface thereof can be planarized.

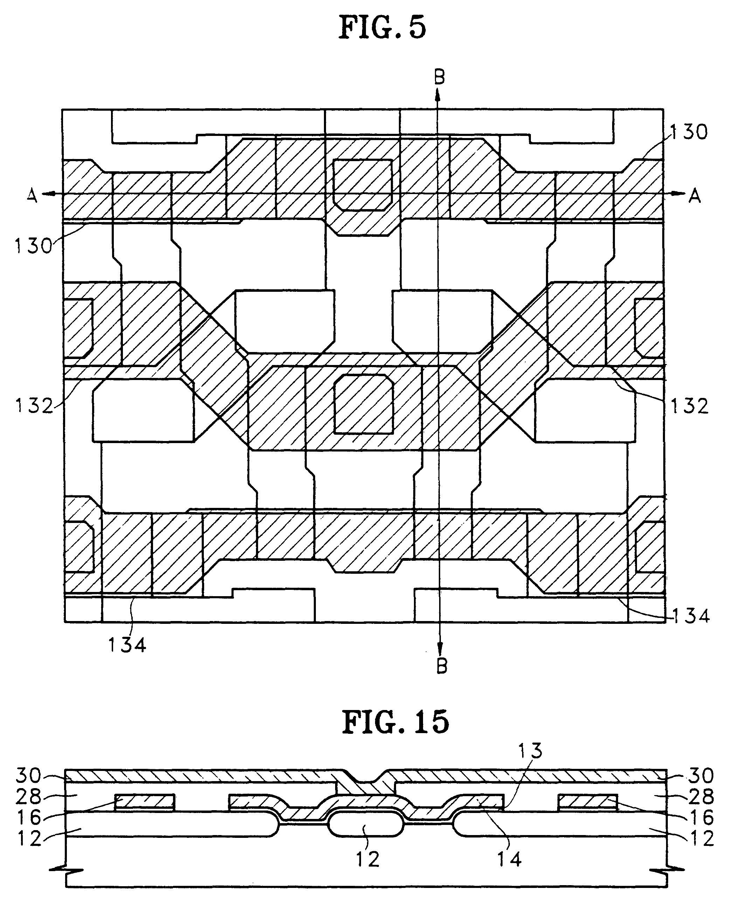

FIGs.5, 15 and 25 illustrate the step for making a first word line 30, a first power supply wiring 32, and a second word line 34, using mask patterns 130, 132 and 134 for forming the first and second word lines and the first power supply wiring.

A conductive material, e.g., polysilicon or a lamination of polysilicon and silicide, is deposited over the entire surface of the resultant substrate where the above first to fourth contact holes are formed, so as to form a second conductive layer (not shown). Then, the second conductive layer is patterned by a photo-etching process using mask patterns 130, 132 and 134, to thus form first word line 30, first power supply wiring 32, and second word line 34. First word line 30 is connected to gate 14 of the first access transistor through the first contact hole (reference numeral 1 in FIG.14), and second word line 34 is connected to the gate of the second access transistor through the fourth contact hole. First power supply wiring 32 is connected to the source regions of the first and second driver transistors through the second and third contact holes, respectively. Here, first power supply wiring 32 is the ground wiring in the present embodiment.

As can be seen in FIG.15, the gates of first and second access transistors and the gates of the first and second driver transistors are disposed on gate insulating film 13, and first and second word lines 30 and 34 are disposed on first insulating layer 28 formed on the gates.

Here, since first and second word lines 30 and 34 are respectively connected to the gates of the first and second access transistors, the same memory cell circuit as is produced by the conventional method (wherein the gate of the access transistor and the word line are formed together from the same layer) can be accomplished.

In the conventional method illustrated in FIG.1, since the word line and the gates of the access transistor and driver transistor are formed together by patterning the same conductive layer, the occupied memory cell area depends on the pitch between the word line and driver transistor gates. On the other hand, according to the present invention as described above, the gate of the access transistor is formed from the first conductive layer and each gate is separated per memory cell unit, and then the word line is formed from the second conductive layer and links each separated gate of the access transistors. Accordingly, the area of the memory cell can be minimized.

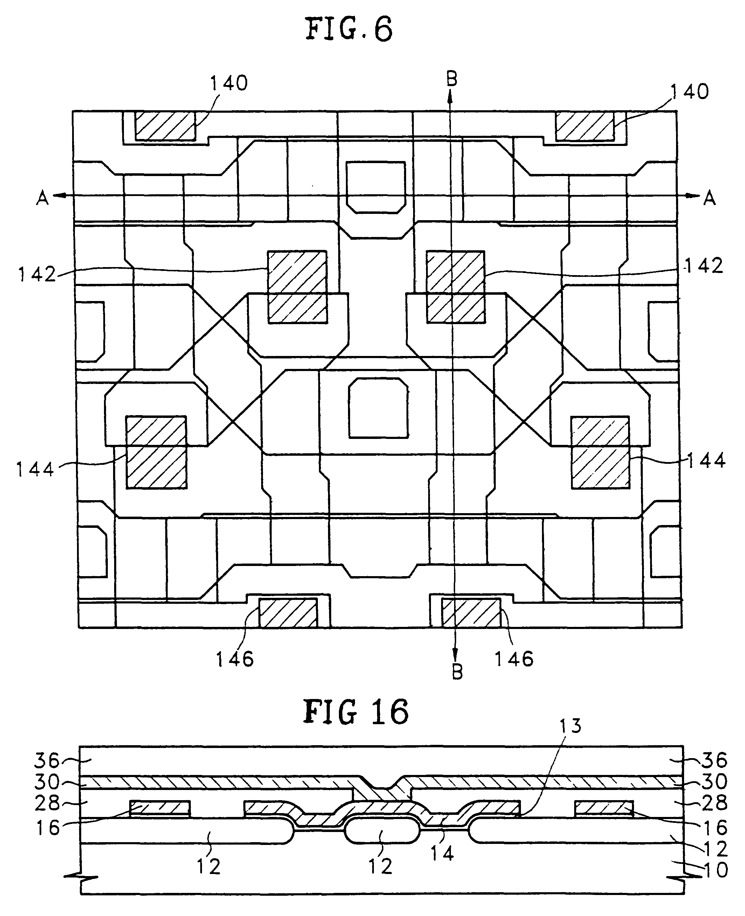

FIGs.6, 16 and 26 illustrate the step for forming a fifth contact hole (not shown) for linking the first pad with drain region 22 of the first access transistor, forming a sixth contact hole 2 for linking the gate of the second PMOS TFT with gate 18 of the second driver transistor and with drain region 20 of the first driver transistor (or the source region of the first access transistor), forming a seventh contact hole (not shown) for linking the gate of the first PMOS TFT with gate 16 of the first driver transistor and with the drain region of the second driver transistor (or the source region of the second access transistor), and forming an eighth contact hole 3 for linking the second pad with drain region 24 of the second access transistor, using mask patterns 140, 142, 144 and 146 for forming the respective contact holes.

After a second insulating layer 36 is formed over the entire surface of the resultant structure where first and second word lines 30 and 34 and first power supply wiring 32 are formed, the second insulating layer is selectively removed according to a photo-etching process using mask patterns 140, 142, 144 and 146. The photo-etching process forms the fifth contact hole for exposing the surface of drain region 22 of the first access transistor, sixth contact hole 2 for exposing gate 18 of the second driver transistor and the surface of the drain region of the first driver transistor, the seventh contact hole for exposing gate 16 of the first driver transistor and the surface of the drain region of the second driver transistor, and eighth contact hole 3 for exposing the surface of drain region 24 of the second access transistor.

Here, the monolayer of oxide film, e.g., the HTO film, is deposited to form second insulating layer 36. If the BPSG as an insulating material is laminated onto the HTO film, the surface thereof becomes planarized.

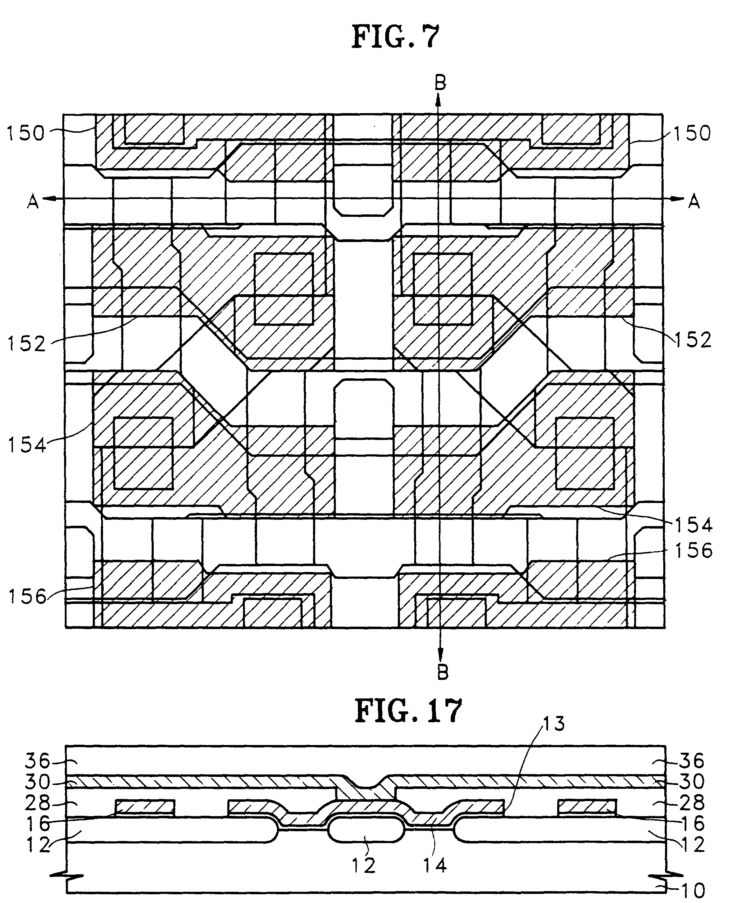

FIGs.7, 17 and 27 illustrate the step for forming a first pad 40, a gate 42 of the second PMOS TFT, a gate 44 of the first PMOS TFT and a second pad 46, using mask patterns 150, 152, 154 and 156 to form the first and second pads, and the gates of the first and second PMOS TFTs.

After a conductive material, e.g., polysilicon, is deposited over the entire surface of the resultant structure where the fifth through eighth contact holes are formed, the polysilicon is patterned by a photo-etching process using mask patterns 150, 152, 154 and 156, thus forming first pad 40, gate 42 of the second PMOS TFT, gate 44 of the first PMOS TFT, and second pad 46. First pad 40 is connected to drain region 22 of the first access transistor through the fifth contact hole so as to contact the first bit line formed in a subsequent process step, and is disposed parallel to first word line 30. Gate 42 of the second PMOS TFT is connected to gate 18 of the second driver transistor and to drain region 20 of the first driver transistor (or source region 20 of the first access transistor) through sixth contact hole 2, so as to be disposed parallel to first pad 40. Gate 44 of the first PMOS TFT is connected to gate 16 of the first driver transistor and to either the drain region of the second driver transistor or the source region of the first access transistor through the seventh contact hole, and likewise disposed parallel to first pad 40. Second pad 46 is connected to drain region 24 of the second access transistor through eighth contact hole 3, so as to be disposed parallel to first pad 40 while contacting to the second bit line formed a subsequent process step.

Here, gate 44 of the first PMOS TFT crosses gate 18 of the second driver transistor so as to be disposed perpendicularly thereto. Also, gate 42 of the second PMOS TFT crosses gate 16 of the first driver transistor so as to be disposed perpendicularly thereto.

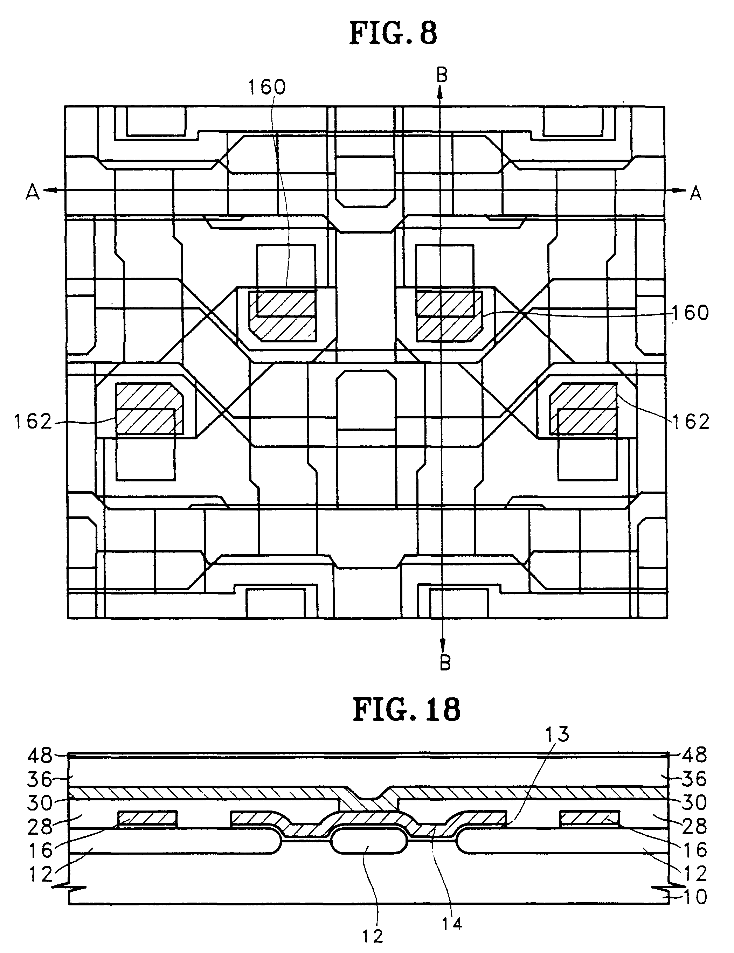

FIGs.8. 18 and 28 illustrate the step for forming a ninth contact hole 4 for linking the drain region of the first PMOS TFT with the source region of the first access transistor (or the drain region of the first driver transistor), a gate 42 of the second PMOS TFT and gate 18 of the second driver transistor, and forming a tenth contact hole (not shown) for linking the drain region of the second PMOS TFT with the source region of the second access transistor (or the drain region of the second driver transistor), a gate 44 of the first PMOS TFT and gate 16 of the first driver transistor, using mask patterns 160 and 162 to form the ninth and tenth contact holes.

An oxide film, e.g., HTO, is deposited thinly over the entire surface of the resultant structure where first pad 40. gate 42 of the second PMOS TFT, gate 44 of the first PMOS TFT, and second pad 46 are formed, so as to form a gate insulating film 48 of the first and second PMOS TFTs. Then, gate insulating film 48 is selectively removed by a photo-etching process using mask patterns 160 and 162, so as to form ninth contact hole 4 for exposing the surface of gate 42 of the second PMOS TFT and the tenth contact hole for exposing the surface of gate 44 of the first PMOS TFT.

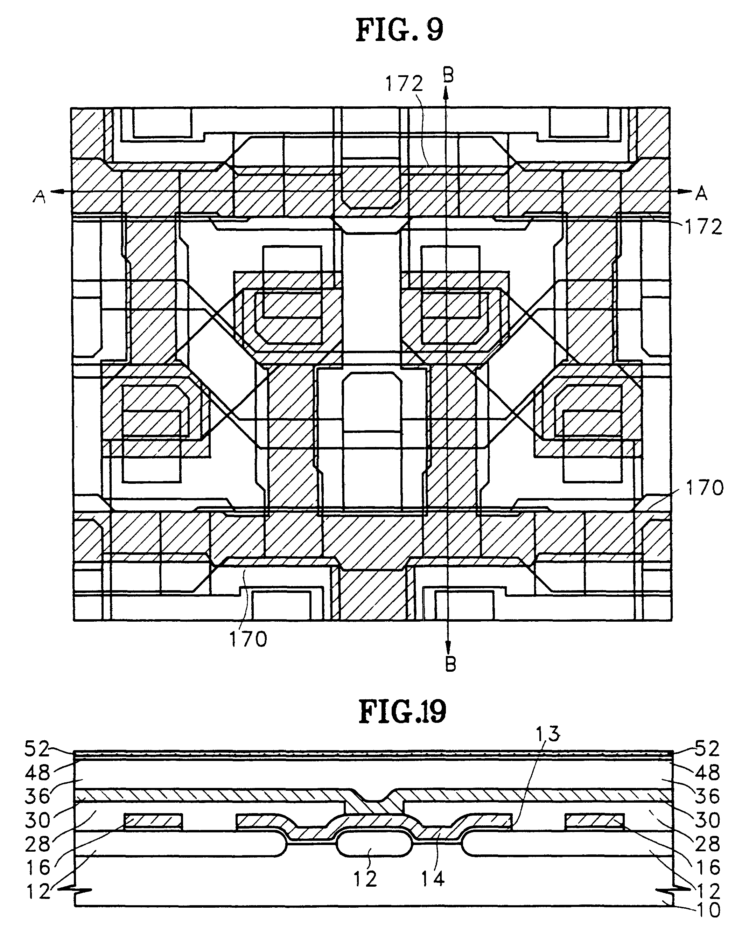

FIGs.9, 19 and 29 illustrate the step for forming a drain region 50, source region 52 and channel region 54 of the first PMOS TFT, the drain, source and channel regions (not shown) of the second PMOS TFT, and second and third power supply wirings 52 and 56, using mask patterns 170 and 172.

After an amorphous silicon is deposited over the entire surface of the resultant structure where the ninth and tenth contact holes are formed, the amorphous silicon is patterned according to a photo-etching process using mask patterns 170 and 172, to thus respectively form the active regions of the first and second PMOS TFTs, and the second and third power supply wiring. Then, an impurity, e.g., boron, is ion-implanted over the resulting structure excluding the areas corresponding to the channel regions of the first and second PMOS TFT (that is, the upper portion of the gates of the first and second PMOS TFTs), so that the active region of the first PMOS TFT is divided into a drain region 50, a source region 52 and a channel region 54, and the active region of the second PMOS TFT is divided into the drain region, the source region and the channel region.

Here, second power supply wiring 52 is connected to source region 52 of the first PMOS TFT to be disposed parallel to second word line 34, and the active region of the first PMOS TFT is connected to second power supply wiring 52 to be disposed perpendicularly with respect to second word line 34. Also, third power supply wiring 56 is connected to the source region (not shown) of the second PMOS TFT to be disposed parallel to first word line 30, and the active region of the second PMOS TFT is connected to third power supply wiring 56 to be disposed perpendicularly with respect to first word line 30.

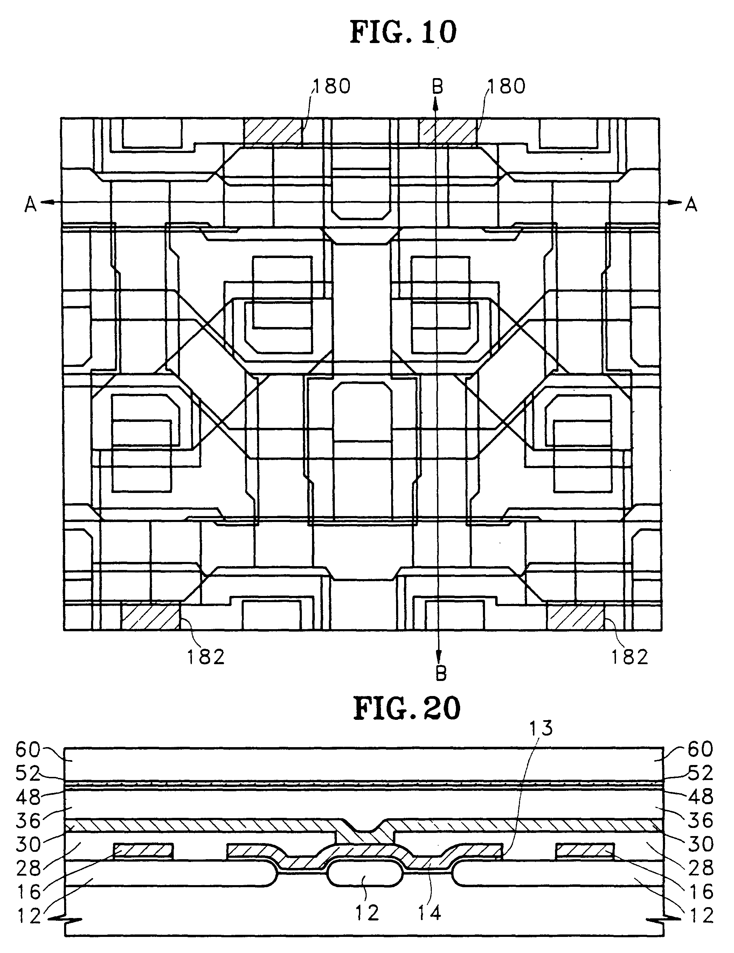

FIGs.10, 20 and 30 illustrate the step for forming an eleventh contact hole 5 for linking the first bit line with first pad 40, and a twelfth contact hole (not shown) for linking the second bit line with second pad 46, using mask patterns 180 and 182, respectively.

After a third insulating layer 60 is formed over the entire surface of the resultant structure where the first and second PMOS TFTs are formed, third insulating layer 60 is selectively removed according to a photo-etching process using mask patterns 180 and 182, so that eleventh contact hole 5 for exposing the surface of first pad 40 and the twelfth contact hole for exposing the surface of second pad 46 are each formed accordingly.

Here, the monolayer of oxide film, e.g., HTO, is deposited to form third insulating layer 60. If the BPSG as an insulating material is laminated over the HTO, the surface thereof becomes planarized.

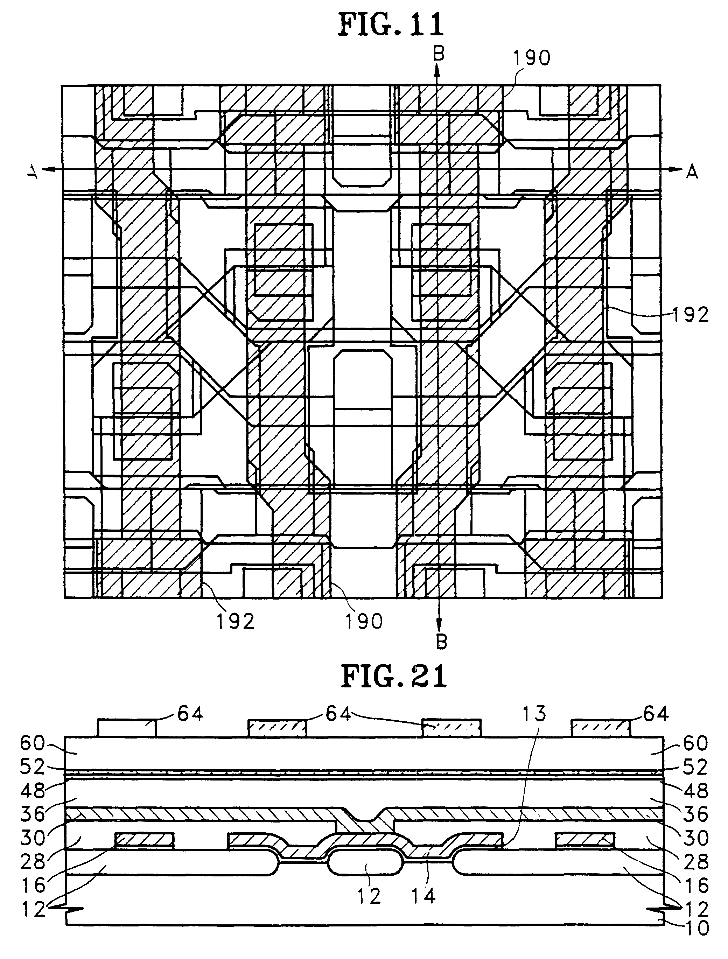

FIGs.11, 21 and 31 illustrate the step for forming a first bit line 62 and a second bit line 64 using mask patterns 190 and 192, respectively.

After a metal, e.g., aluminum, is deposited over the entire surface of the resultant structure where the eleventh and twelfth contact holes are formed, the aluminum is patterned according to a photo-etching process using mask patterns 190 and 192, and thus forming first bit line 62 and second bit line 64. First bit line 62 makes contact with first pad 40 through eleventh contact hole 5 to thereby be connected to drain region 22 of the first access transistor, and second bit line 64 makes contact with second pad 46 through twelfth contact hole to thereby be connected to drain region 24 of the second access transistor.

Here, first and second bit lines 62 and 64 are disposed perpendicularly with respect to first and second word lines 30 and 34, respectively.

FIGs.2-11, 12-21 and 22-31 illustrate respectively the diagrams of each layout of the SRAM cell and two cross-sectional views thereof, wherein the PMOS TFT of the bottom gate structure is used as a load element and the PMOS TFT of the top gate structure (or the PMOS TFT of the double-gate structure) can be adopted as the load element. In the present invention, the gate of the access transistor is formed from a different layer than that of the word line, so that the area occupied by the unit memory cell is minimized.

Accordingly, as described above, the present invention the gates of the access transistors are separated per each unit memory cell and formed from the different conductive layer where the word line is formed, so that the above word line connects the separated gates of the access transistors.

The word line is formed on the insulating layer for insulating the gates of the access transistors from the word line, and the wordline is electrically connected with the gates through the contact hole formed in the insulating layer.

Also, each memory cell is arranged symmetrically with respect to its adjacent memory cell, and the paired components of each memory cell are arranged symmetrically with respect to each other.

Accordingly, the area occupied by a unit memory cell can be reduced remarkably while maintaining the conventional design rule. Also, the layout margin is increased so that a more reliable memory cell can be realized.

## Claims

1. A semiconductor memory device including a first memory cell composed of cross-connected flip flops in which a first inverter having a first access transistor (14,20,22) and first driver transistor (16) and a second inverter having a second access transistor (24) and second driver transistor (18) form one flip-flop and a third inverter having a first load element and the first driver transistor (16) and a fourth inverter having a second load element and the second driver transistor (18) form the other flip-flop said device comprising:
a semiconductor substrate (10);
a first conductive layer formed on said substrate wherein said first and second access transistors each have a gate (14) formed from said first conductive layer;
an insulating layer (28) formed on said first and second access transistor gates (14), said insulating layer (28) having a first and second contact hole (1) therein to expose said first and second access transistor gates (14), respectively;
a second conductive layer formed on said insulating layer (28);
a first and second word line (30,34) formed from said second conductive layer, said first word line (30) being connected to said first access transistor gate (14) through said first contact hole (1), and said second word line (34) being connected to said second access transistor gate through said second contact hole. wherein said first and second access transistor gates (14) are disposed parallel to said first and second word lines (30,34) respectively and said first and second driver transistor gates (16,18) are formed perpendicular to said first and second access transistors gates (14) respectively and wherein said first access transistor gate (14) of said first memory cell is connected to a first access transistor gate of an adjacent second memory cell and,
said second access transistor gate of said first memory cell is connected to a second access transistor gate of an oppositely adjacent third memory cell;
said first access transistor gate (14) of said first memory cell does not directly contact a first access transistor gate of said third memory cell; and,
said second access transistor gate of said first memory cell does not directly contact a second access transistor gate of said second memory cell.

2. A semiconductor memory device according to claim 1, further comprising:
a second insulating layer (36) formed on said second conductive layer, said first and second word lines (30,34) being disposed on said second insulating layer (36); and
a ground line formed on said second insulating layer (36) and disposed parallel to said first word line (30).

3. A semiconductor memory device according to claim 1, further comprising:
first and second driver transistor gates (16,18) disposed near a centre of said first memory cell;
wherein said first and second access transistor gates (14) are disposed near an edge of said first memory cell.

4. A semiconductor memory device according to claim 1, wherein:
said first and second access transistor gates (14) are formed perpendicular to said first and second driver transistor gates (16,18); and
said first and second access transistor gates (14) are formed parallel to said first and second word lines (30,34).

5. A semiconductor memory device according to claim 1, wherein:
said first memory cell is symmetrical in formation to said second memory cell; and
said first memory cell is symmetrical in formation to said third memory cell.

6. A semiconductor memory device according to claim 1, further comprising:
first and second driver transistor gates (16,18) disposed near a centre of said first memory cell;
wherein said first and second access transistors (14,20,22;24) and said first and second driver transistors (16.18) of said first memory cell are adjacent to a second memory cell.

7. A semiconductor memory device according to claim 1, further comprising a first and second load element.

8. A semiconductor memory device according to claim 7, wherein said first and second load elements (42,44) are bottom-gated PMOS thin film transistors.

9. A semiconductor memory device according to claim 7, wherein said first and second load elements (42,44) are top-gated PMOS thin film transistors.

10. A semiconductor memory device according to claim 7, wherein said first and second load elements (42,44) are double-gated PMOS thin film transistors.

11. A semiconductor memory device according to claim 7, wherein said first and second load elements (42,44) are high-resistance polysilicon.

## Patentansprüche

1. Halbleiterspeicherbauelement mit einer ersten Speicherzelle, die aus kreuzgekoppelten Flip-Flops besteht, bei denen ein erster Inverter mit einem ersten Zugriffstransistor (14, 20, 22) und einem ersten Treibertransistor (16) sowie ein zweiter Inverter mit einem zweiten Zugriffstransistor (24) und einem zweiten Treibertransistor (18) das eine Flip-Flop bilden und ein dritter Inverter mit einem ersten Lastelement und dem ersten Treibertransistor (16) sowie ein vierter Inverter mit einem zweiten Lastelement und dem zweiten Treibertransistor (18) das andere Flip-Flop bilden, wobei das Bauelement beinhaltet:
ein Halbleitersubstrat (10);
eine erste leitfähige Schicht, die auf dem Substrat ausgebildet ist, wobei der erste und der zweite Zugriffstransistor jeweils ein aus der ersten leitfähigen Schicht gebildetes Gate (14) aufweisen;
eine isolierende Schicht (28), die auf den Gates (14) des ersten und des zweiten Zugriffstransistors ausgebildet ist, wobei die isolierende Schicht (28) eine erste und eine zweite Kontaktöffnung (1) darin aufweist, um die Gates (14) des ersten beziehungsweise des zweiten Zugriffstransistors freizulegen;
eine zweite leitfähige Schicht, die auf der isolierenden Schicht (28) ausgebildet ist;
eine erste und eine zweite Wortleitung (30, 34), die aus der zweiten leitfähigen Schicht gebildet sind, wobei die erste Wortleitung (30) mit dem Gate (14) des ersten Zugriffstransistors durch die erste Kontaktöffnung (1) verbunden ist und die zweite Wortleitung (34) mit dem Gate des zweiten Zugriffstransistors durch die zweite Kontaktöffnung verbunden ist, wobei die Gates (14) des ersten und des zweiten Zugriffstransistors parallel zu der ersten beziehungsweise der zweiten Wortleitung (30, 34) angeordnet sind und die Gates (16, 18) des ersten und des zweiten Treibertransistors senkrecht zu den Gates (14) des ersten beziehungsweise des zweiten Zugriffstransistors ausgebildet sind und wobei das Gate (14) des ersten Zugriffstransistors der ersten Speicherzelle mit dem Gate eines ersten Zugriffstransistors einer angrenzenden zweiten Speicherzelle verbunden ist, und
das Gate des zweiten Zugriffstransistors der ersten Speicherzelle mit dem Gate eines zweiten Zugriffstransistors einer gegenüberliegend benachbarten dritten Speicherzelle verbunden ist;
das Gate (14) des ersten Zugriffstransistors der ersten Speicherzelle nicht in direktem Kontakt zu dem Gate eines ersten Zugriffstransistors der dritten Speicherzelle steht; und
das Gate des zweiten Zugriffstransistors der ersten Speicherzelle nicht in direktem Kontakt zu dem Gate eines zweiten Zugriffstransistors der zweiten Speicherzelle steht.

2. Halbleiterspeicherbauelement nach Anspruch 1, das des Weiteren beinhaltet:
eine zweite isolierende Schicht (36), die auf der zweiten leitfähigen Schicht ausgebildet ist, wobei die erste und die zweite Wortleitung (30, 34) auf der zweiten isolierenden Schicht (36) angeordnet sind; und
eine Masseleitung, die auf der zweiten isolierenden Schicht (36) ausgebildet und parallel zu der ersten Wortleitung (30) angeordnet ist.

3. Halbleiterspeicherbauelement nach Anspruch 1, das des Weiteren beinhaltet:
Gates (16, 18) eines ersten und zweiten Treibertransistors, die nahe eines Mittenbereichs der ersten Speicherzelle angeordnet sind;
wobei die Gates (14) des ersten und des zweiten Zugriffstransistors nahe einer Kante der ersten Speicherzelle angeordnet sind.

4. Halbleiterspeicherbauelement nach Anspruch 1, wobei:
die Gates (14) des ersten und des zweiten Zugriffstransistors senkrecht zu den Gates (16, 18) des ersten und des zweiten Treibertransistors ausgebildet sind; und
die Gates (14) des ersten und des zweiten Zugriffstransistors parallel zu der ersten und der zweiten Wortleitung (30, 34) ausgebildet sind.

5. Halbleiterspeicherbauelement nach Anspruch 1, wobei:
die erste Speicherzelle in der Formation symmetrisch zur zweiten Speicherzelle ist; und
die erste Speicherzelle in der Formation symmetrisch zur dritten Speicherzelle ist.

6. Halbleiterspeicherbauelement nach Anspruch 1, das des Weiteren beinhaltet:
Gates (16, 18) eines ersten und zweiten Treibertransistors, die nahe eines Mittenbereichs der ersten Speicherzelle angeordnet sind;
wobei der erste und der zweite Zugriffstransistor (14, 20, 22, 24) und der erste und der zweite Treibertransistor (16, 18) der ersten Speicherzelle zu einer zweiten Speicherzelle benachbart sind.

7. Halbleiterspeicherbauelement nach Anspruch 1, das des Weiteren ein erstes und ein zweites Lastelement beinhaltet.

8. Halbleiterspeicherbauelement nach Anspruch 7, wobei das erste und das zweite Lastelement (42, 44) PMOS-Dünnfilmtransistoren mit unterseitigem Gate sind.

9. Halbleiterspeicherbauelement nach Anspruch 7, wobei das erste und das zweite Lastelement (42, 44) PMOS-Dünnfilmtransistoren mit oberseitigem Gate sind.

10. Halbleiterspeicherbauelement nach Anspruch 7, wobei das erste und das zweite Lastelement (42, 44) PMOS-Dünnfilmtransistoren mit Doppelgate sind.

11. Halbleiterspeicherbauelement nach Anspruch 7, wobei das erste und das zweite Lastelement (42, 44) aus hochohmigem Polysilicium bestehen.

## Revendications

1. Dispositif de mémoire à semiconducteur comportant une première cellule de mémoire constituée de bascules interconnectées dans lequel un premier inverseur comportant un premier transistor d'accès (14, 20, 22) et un premier transistor de commande (16) et un deuxième inverseur comportant un second transistor d'accès (24) et un second transistor de commande (18) constituent une bascule et un troisième inverseur comportant un premier élément de charge et le premier-transistor de commande (16) et un quatrième inverseur comportant un second élément de charge et le second transistor de commande (18) constituent l'autre bascule, ledit dispositif comprenant :
un substrat semiconducteur (10) ;
une première couche conductrice formée sur ledit substrat, où lesdits premier et second transistors d'accès ont chacun une grille (14) formée sur ladite première couche conductrice ;
une couche isolante (28) formée sur les grilles desdits premier et second transistors d'accès (14), ladite couche isolante (28) comportant un premier et un deuxième trou de contact (1) dans celle-ci pour exposer respectivement les grilles desdits premier et second transistors d'accès (14) ;
une seconde couche conductrice formée sur ladite couche isolante (28) ;
une première et une seconde ligne de mot (30, 34) formées à partir de ladite seconde couche conductrice, ladite première ligne de mot (30) étant connectée à la grille dudit premier transistor d'accès (14) par l'intermédiaire dudit premier trou de contact (1) et ladite seconde ligne de mot (34) étant connectée à la grille dudit second transistor d'accès par l'intermédiaire dudit deuxième trou de contact, où les grilles desdits premier et second transistors d'accès (14) sont respectivement disposées parallèlement auxdites première et deuxième lignes de mot (30, 34), et les grilles desdits premier et second transistors de commande (16, 18) sont respectivement formées perpendiculairement aux grilles desdits premier et second transistors d'accès (14) et où la grille dudit premier transistor d'accès (14) de ladite première cellule de mémoire est connectée à la grille du premier transistor d'accès d'une deuxième cellule de mémoire adjacente et,
la grille dudit second transistor d'accès de ladite première cellule de mémoire est connectée à la grille d'un second transistor d'accès d'une troisième cellule de mémoire adjacente opposée ;
la grille dudit premier transistor d'accès (14) de ladite première cellule de mémoire n'est pas directement en contact avec la grille du premier transistor d'accès de ladite troisième cellule de mémoire ; et
la grille dudit second transistor d'accès de ladite première cellule de mémoire n'est pas directement en contact avec la grille du second transistor d'accès de ladite deuxième cellule de mémoire.

2. Dispositif de mémoire à semiconducteur selon la revendication 1, comprenant en outre :
une deuxième couche isolante (36) formée sur ladite seconde couche conductrice, lesdites première et deuxième lignes de mot (30,34) étant disposées sur ladite deuxième couche isolante (36) ; et une ligne de base formée sur ladite seconde couche isolante et disposée parallèlement à ladite première ligne de mots disposées parallèlement à ladite première ligne de mot (30).

3. Dispositif de mémoire à semiconducteur selon la revendication 1, comprenant en outre :
des grilles des premier et second transistors de commande (16, 18) disposées près du centre de ladite première cellule de mémoire ;
dans lequel lesdites grilles des premier et second transistors d'accès (14) sont disposées près d'un bord de ladite première cellule de mémoire.

4. Dispositif de mémoire à semiconducteur selon la revendication 1, dans lequel :
lesdites grilles des premier et second transistors d'accès (14) sont formées perpendiculairement audites grilles des premier et second transistors de commande (16, 18) ; et
lesdites grilles des premier et second transistors d'accès (14) sont formées parallèlement auxdites première et deuxième lignes de mot (30, 34).

5. Dispositif de mémoire à semiconducteur selon la revendication 1, dans lequel :
ladite première cellule de mémoire est de formation symétrique par rapport à ladite deuxième cellule de mémoire ; et
ladite première cellule de mémoire est de formation symétrique par rapport à ladite troisième cellule de mémoire.

6. Dispositif de mémoire à semiconducteur selon la revendication 1, comprenant en outre :
des grilles des premier et second transistors de commande (16, 18) disposées près du centre de ladite première cellule de mémoire ;
dans lequel lesdits premier et second transistors d'accès (14, 20, 22, 24) et lesdits premier et second transistors de commande (16, 18) de ladite première cellule de mémoire sont adjacents à une deuxième cellule de mémoire.

7. Dispositif de mémoire à semiconducteur selon la revendication 1, comprenant en outre un premier et un second élément de charge.

8. Dispositif de mémoire à semiconducteur selon la revendication 7, dans lequel lesdits premier et second éléments de charge (42, 44) sont des transistors PMOS à film mince à grille inférieure.

9. Dispositif de mémoire à semiconducteur selon la revendication 7, dans lequel lesdits premier et second éléments de charge (42, 44) sont des transistors PMOS à film mince à grille supérieure.

10. Dispositif de mémoire à semiconducteur selon la revendication 7, dans lequel lesdits premier et second éléments de charge (42, 44) sont des transistors PMOS à film mince à double grille.

11. Dispositif de mémoire à semiconducteur selon la revendication 7, dans lequel lesdits premier et second éléments de charge (42, 44) sont faits de silicium polycristallin à haute résistance.
